# EUROPEAN PATENT APPLICATION

(11) **EP 1 729 421 A2**
(43) Date of publication of application: **06.12.2006**
(21) Application number: 06010712.5
(22) Date of filing: 24.05.2006
(51) Int. Cl.: H03M 7/30

(54) **Method for compressing short messages in a mobile communication terminal**

(30) Priority: 25.05.2005 KR 20050043915
(71) Applicant: LG Electronics Inc., Seoul 150-721 (KR)
(72) Inventor: Lee, Hong-Seok, Suwon-si Gyeonggi-do 440-330 (KR)
(74) Representative: TER MEER - STEINMEISTER & PARTNER GbR

(57) **Abstract**

A method and mobile terminal for compressing message content includes receiving an original message comprising user-supplied content, the original message having a message size which varies based upon the user-supplied content. A compressed message may be generated by modifying the user-supplied content according to at least one automatic compression process, such that the compressed message has a message size which is less than the message size of the original message.

## Description

### CROSS-REFERENCE TO RELATED APPLICATIONS

Pursuant to 35 U.S.C. § 119(a), this application claims the benefit of earlier filing date and right of priority to Korean Application No. 10-2005-0043915, filed on May 25, 2005, the contents of which are hereby incorporated by reference herein in their entirety

### BACKGROUND OF THE INVENTION

### Field of the Invention

The present invention relates to a mobile communication terminal, and in particular to compressing message content transmitted by a mobile communication terminal.

### Discussion of the Related Art

The wide spread use of cellular phones and other types of mobile communication terminals has caused an increase in demand for messaging as a form of communication. One popular type of messaging is the short message service (SMS). SMS may be used to quickly transfer contents in the form of a relatively short text string. The length of the SMS message is limited, with maximum message length typically ranging from about 40-160 characters.

If a generated SMS message exceeds the maximum message length, the user if faced with several options. One option is to send the message as two or more separate SMS messages. A disadvantage with this option is that the user may incur additional charges for sending two messages. In addition, the sending of two separate messages requires additional effort by the user. A second option is to manually delete unnecessary content from the message (e.g., spaces, special characters, punctuation, and the like) so that the message meets the message length requirements. However, deleting of content is time consuming and may make the transmitted message difficult to understand. Accordingly, for situations in which a message exceeds the maximum message size limit, there is a need for quickly and easily compressing the message so that it is suitable for transmitting.

### SUMMARY OF THE INVENTION

Features and advantages of the invention will be set forth in the description which follows, and in part will be apparent from the description, or may be learned by practice of the invention. The objectives and other advantages of the invention will be realized and attained by the structure particularly pointed out in the written description and claims hereof, as well as the appended drawings.

In accordance with an embodiment, a method for compressing message content includes receiving an original message comprising user-supplied content, the original message having a message size which varies based upon the user-supplied content. The method also includes generating a compressed message by modifying the user-supplied content according to at least one automatic compression process, such that the compressed message has a message size which is less than the message size of the original message.

In one feature, the compression process may include one or more (and any combination thereof) compression processes such as removing any spaces individually located between separate characters contained within the user-supplied content, changing predetermined common words contained within the user-supplied content into a relatively smaller assigned word, removing any special characters contained within the user-supplied content, changing any words contained within the user-supplied content that have assigned abbreviations into the abbreviations, and removing any characters contained within the user-supplied content which exceed a maximum message size limit. If desired, these processes may be performed until the message size of the compressed message meets a predetermined size threshold.

In another aspect, the method further includes highlighting a character of the compressed message which was adjacent to the spaces removed from between the separate characters, highlighting the assigned word within the compressed message and a character in the compressed message which is adjacent to the assigned word, highlighting a character of the compressed message which was adjacent to any of the special characters, highlighting the abbreviations within the compressed message and a character in the compressed message which is adjacent to the abbreviations.

In yet another aspect, the compressed message is generated by a plurality of compression processes, and the method further includes setting priority which determines relative order that each compression process of the plurality of compression processes is performed. In some cases, the priority causes the removing of any spaces to occur first, the changing of any common words to occur second, the removing of any special characters to occur third, and the changing of any words to occur fourth.

In one feature, the method further includes detecting that the message size of the original message exceeds a predetermined size threshold.

In another feature, the method further includes highlighting portions of the compressed message which correspond to the user-supplied content modified according to the compression process. In one option, the highlighting includes displaying the highlighted portions of the compressed message in at least one of a different color, font, and size than that used to display non-highlighted portions of the compressed message.

In yet another aspect, the method further includes registering common words with assigned words suitable for the compression process.

In still yet another aspect, generating the compressed message is performed responsive to user input or it is performed automatically whenever the original message exceeds a predetermined size threshold.

In another feature, the method further includes displaying a message size indicator which represents the message size of the original message.

In yet another feature, the method further includes restoring the compressed message to the original message responsive to user input.

In still yet another feature, the compressed message is a message selected from the group consisting of a short message service (SMS) message, an enhanced message service (EMS) message, and a multimedia message service (MMS) message.

In accordance with another embodiment, a mobile terminal includes a key input unit for receiving an original message comprising user-supplied content, such that the original message has a message size which varies based upon the user-supplied content. The terminal also includes a control unit for generating a compressed message by modifying the user-supplied content according to at least one automatic compression process, such that the compressed message has a message size which is less than the message size of the original message.

In accordance with yet another embodiment, a control unit for a mobile terminal is configured to receive an original message comprising user-supplied content, such that the original message has a message size which varies based upon the user-supplied content. The control unit is further configured to generate a compressed message by modifying the user-supplied content according to at least one automatic compression process, such that the compressed message has a message size which is less than the message size of the original message.

These and other embodiments will also become readily apparent to those skilled in the art from the following detailed description of the embodiments having reference to the attached figures, the invention not being limited to any particular embodiment disclosed.

### BRIEF DESCRIPTION OF THE DRAWINGS

The accompanying drawings, which are included to provide a further understanding of the invention and are incorporated in and constitute a part of this specification, illustrate embodiments of the invention and together with the description serve to explain the principles of the invention. Features, elements, and aspects of the invention that are referenced by the same numerals in different figures represent the same, equivalent, or similar features, elements, or aspects in accordance with one or more embodiments. In the drawings:

FIG. 1 is a schematic block diagram of a mobile communication terminal in accordance with an embodiment of the present invention;

FIG. 2 is a schematic block diagram providing a more detailed view of various components of the control unit shown in FIG. 1;

FIG. 3 is a flowchart depicting a method for compressing a message in a mobile communication terminal according to an embodiment of the present invention;

FIG. 4 is a flowchart depicting a SMS message compression process in accordance with an embodiment of the present invention;

FIGS. 5A-5D depict a portion of a display of a typical mobile terminal and individually show various aspects of message creation and compression according to various embodiments of the present invention;

FIGS. 5E and 5F each depict compressed SMS messages in which changes made to the original message have been highlighted in the compressed message; and

FIG. 6 depicts a registration window in which a user may register common words and corresponding assigned words.

### DETAILED DESCRIPTION OF THE PREFERRED EMBODIMENTS

Reference will now be made in detail to the preferred embodiments of the present invention, examples of which are illustrated in the accompanying drawings. Wherever possible, the same reference numbers will be used throughout the drawings to refer to the same or similar parts.

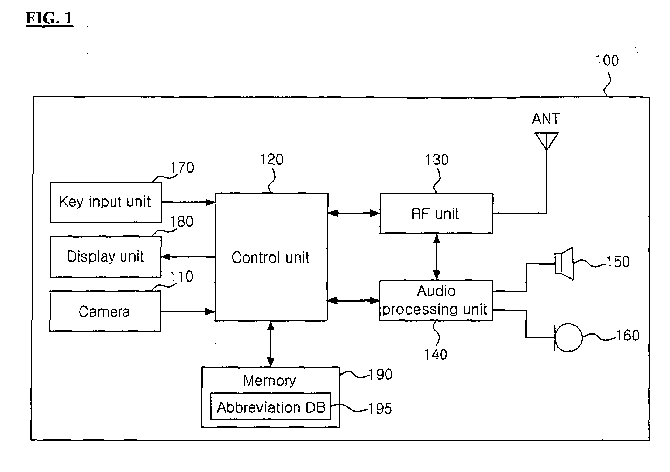

FIG. 1 is a schematic block diagram of a mobile communication terminal in accordance with an embodiment of the present invention. In this figure, terminal 100 includes control unit 120 for compressing a message inputted by a user. Message compression may be accomplished using a predetermined, priority-based, or other type of compression process. Examples of such compression processes will be described in more detail in conjunction with later figures.

The terminal further includes RF unit 130, audio processing unit 140, speaker 150, microphone 160, key input unit 170, and display unit 180, which may include an external window and/or an internal window. The terminal is also shown configured with optional camera 110.

Control unit 120 controls RF unit 130, which transforms signals outputted from the control unit into radio signals. Conversely, the RF unit transforms radio signals received through an antenna (ANT) into desired signals and outputs the transformed signals as required to audio processing unit 140 and control unit 120.

Audio processing unit 140 modulates audio signals inputted via microphone 160, and transforms the received audio signals into audio data. The audio processing unit also demodulates audio data provided by RF unit 130, and in some cases memory 190, into audio signals which are output as sound through speaker 150.

Key input unit 170 typically includes numeric keys, menu keys, and various function keys, and provides output key data to control unit 120 responsive to user manipulation. An SMS message may be created and ultimately communicated to others by manipulating various keys of the key input unit.

During operation, a user may request to display a menu using key input unit 170. In response, control unit 120 reads a predetermined menu from memory 190 and displays the menu on display unit 180. Display unit 180 may be implemented using a display device, such as a liquid crystal display (LCD). The display unit may be used to display the state of a mobile communication terminal, or a progress state of a program under the control of control unit 120.

If desired, display unit 180 may also display information relating to an SMS message inputted by a user. For instance, the display unit may display the actual message size or as a percentage of a maximum size of a message that can be communicated in a single transmission. This feature permits the user to easily determine whether or not the message exceeds the maximum message length, or to what extent the message requires compression.

Memory 190 may be implemented using one or more different types of memory devices including ROM, RAM, EEPROM, flash memory, and the like. Memory 190 may be used to store system and operating programs necessary to support control unit 120. The operating and system programs are generally stored in ROM, while RAM may be used for temporarily storing generated data. Memory 190 is also shown having an abbreviation database (DB) 195 formed using dictionary, user-defined, or other abbreviations, for example.

For simplicity, embodiments of the present invention will be described with a primary focus on SMS messages, but such teachings apply equally to other messaging types such as enhanced message service (EMS) messages, and multimedia message service (MMS) messages, among others. The EMS message transmission limit is typically about 255 pages, with each page containing about 160 bytes of data. Thus, EMS message compression may therefore include techniques for reducing the number of pages necessary to transmit the EMS message. SMS message transmission limits, on the other hand, are typically about 80 bytes. Consequently, SMS message compression therefore may include techniques for reducing the size of the message so that it can be transmitted using a single transmission.

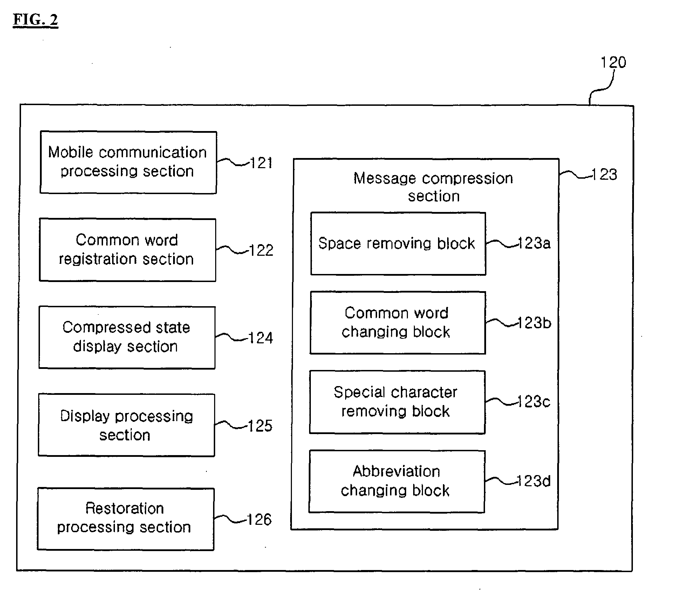

FIG. 2 is a schematic block diagram providing a more detailed view of various components of the control unit shown in FIG. 1 Referring to FIG. 2, control unit 120 is shown having mobile communication processing section 121 for processing signals to perform mobile communication services. Mobile communication processing section 121 is often implemented as a module for performing mobile communication services in the mobile communication terminal. Since this section may be configured and operated using well-known mobile communication technologies, further description will be omitted for clarity.

Common word registration section 122 may be used for registering common words with associated compressed forms of these words. The common words and associated compressed forms of the words may be user-defined, system-defined, or combinations thereof. For instance, a common word "hello" may be associated with the word "hi." In this example, "hello" is matched or otherwise assigned to the relatively shorter word "hi."

Message compression section 123 may be used for compressing a message by modifying the contents of the message through one or more processes. Examples of such compression processes include removing spaces contained within the message (block 123a), changing common words (block 123b), removing special characters (block 123c), and changing a word to its abbreviated form (123d).

Compressed state display section 124 is often used for displaying a compressed message, after such message has been compressed by message compression section 123.

Display processing section 125 displays the compressed message in such a manner to highlight or otherwise identify various changes made to the original message as a result of the compression process. Techniques for identifying such changes include changing one or more of the following: color, font, size, and the like. Identifying those portions of the original message that have been changed permits those who ultimately receive the compressed message to easily recognize the changed portions.

Several nonlimiting examples for highlighting changes made during a typical compression process will now be presented. Characters adjacent to the deleted spaces may be identified using the above-noted highlighting techniques when a space contained within an original message is removed as a result of a compression process (block 123a).

The modified common word may be identified when an original common word is changed (block 123b). If desired, one or more characters adjacent to the modified common word may additionally or alternatively be identified.

One or more characters adjacent to the removed special character may be highlighted in the compressed message when a special character is removed (block 123c). Lastly, an abbreviated word may be identified when a particular word is changed to its abbreviated form (block 123d).

Restoration processing section 126 may be implemented to restore a compressed message to its original state (i.e., the original message). Restoration of a compressed message may be performed according to a message restoration request, and then subsequently displayed to the user as may be required or desired. The message restoration request may be submitted by a user selecting a restoration request from an appropriate menu.

In view of the foregoing, a user can compress an original message by eliminating unnecessary or undesirable text, characters, or other message content (e.g., spaces, common words, special characters, and the like). Accordingly, in an SMS environment, an SMS message that exceeds the maximum SMS message length may be quickly and easily compressed to a particular or desired message length suitable for transmitting. Moreover, in the case of an EMS message, the number of pages to be transferred can be reduced by compressing the contents of the original message contained in the pages using one or more of the compression processes described herein

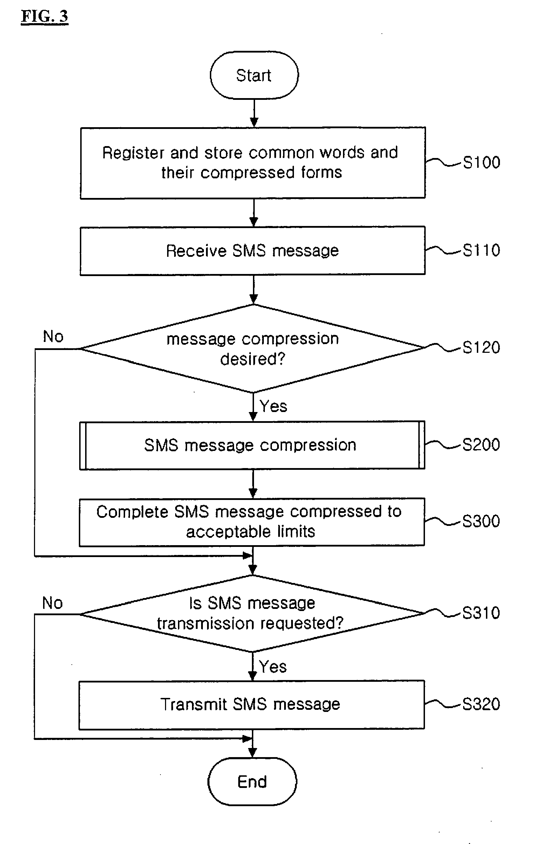

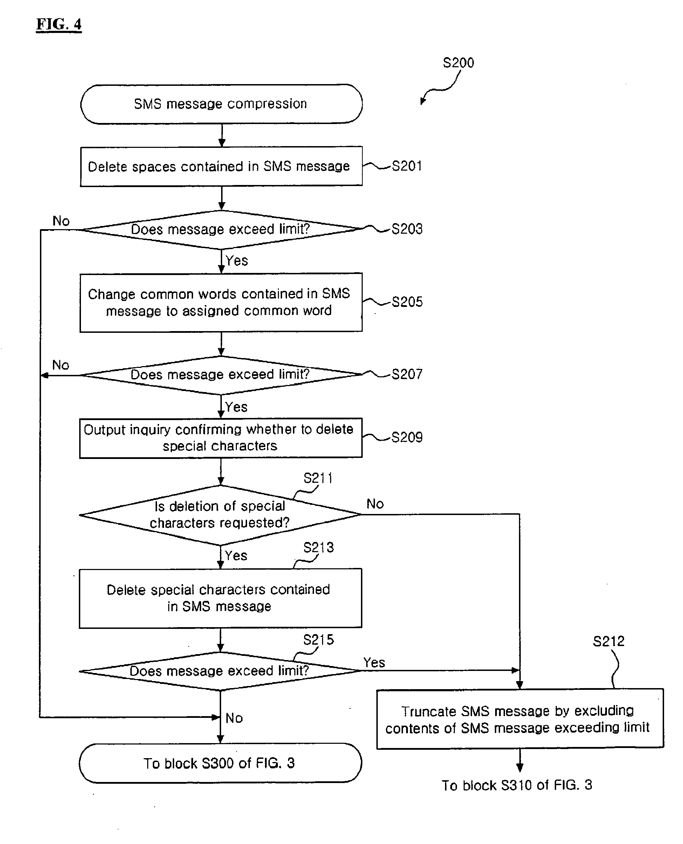

Fig. 3 is a flowchart depicting a method for compressing a message in a mobile communication terminal according to an embodiment of the present invention. By way of example only, this method will be described in conjunction with the mobile terminal depicted in FIG. 1.

In a typical application, prior to message input and compression, common words and their associated compressed forms are registered and stored (e.g., memory 190) for later use during a compression process (block S100). In a similar registration process, particular words may be registered or otherwise associated with their particular abbreviations. These abbreviations will be substituted for their associated words during a compression process. Typically, these abbreviations are stored in abbreviation database 195.

At block S110, control unit 120 receives a message (e.g., an SMS message, an EMS message, a multimedia message service (MMS) message, and the like) from a user. This message will be referred to as an original message. Input of the original message may be accomplished by manipulating the various keys of key input unit 170. The original message may include various characters associated with one or more languages (e.g., English, Korean, Spanish, and Chinese, among others), spaces, special characters, punctuation, and the like.

At decision block S120, control unit 120 determines if message compression has been selected by the user or is otherwise desired or necessary. A SMS message which exceeds the single-message transmission limits is one example of when message compression may be needed or desired. If message compression is not necessary, control flows to decision block S310. On the other hand, if message compression is necessary (e.g., the SMS message exceeds transmission size limit), control flows to block S200.

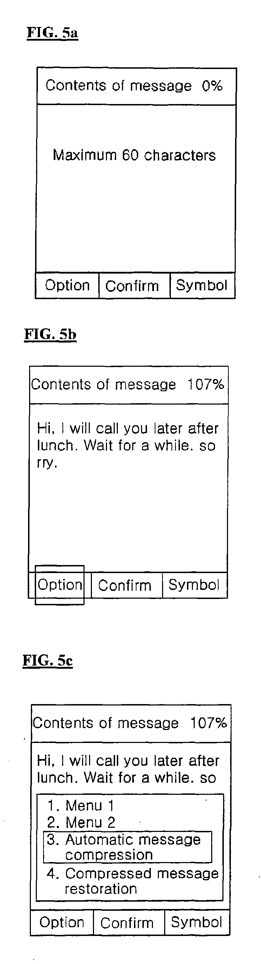

At block S200, the original SMS message is compressed to form a compressed SMS message which has a reduced size relative to the original SMS message. This compression may be accomplished using any of the message compression techniques described herein. Specific examples of these compression techniques will be described in more detail in conjunction with the flowchart of FIG. 4. Typically, control unit 120 stores the original and compressed SMS message in memory 190.

At block S300, the compressed SMS message is now within the maximum message size limit and is acceptable for transmitting in a single transmission. Decision block S310 determines if there is a transmission request for transmitting the compressed SMS message. If there is no such request, further processing may be terminated. On the other hand, if there is a transmission request, the compressed SMS message is transmitted to one or more identified locations (e.g., other mobile terminals) in accordance with the transmission request (block S320).

Block S200 of FIG. 3 refers to SMS message compression operations. Various techniques for providing such compression operations will now be described in conjunction with FIG. 4.

FIG. 4 is a flowchart depicting a SMS message compression process in accordance with an embodiment of the present invention. At block S201, some or all of the spaces contained within an original SMS message are deleted or otherwise removed. This operation is typically accomplished by searching for the spaces within the SMS message starting at the beginning of the message, and then deleting identified spaces in the order in with they appear in the message.

If desired, the removed spaces may be identified in the compressed SMS message using any of the above-described identification techniques. For instance, one or more characters adjacent to the deleted space may be highlighted (e.g., different color, font, size, and the like) relative to the other characters of the message.

Decision block S203 determines if the compressed SMS message (i.e., the SMS message having undesired spaces removed) is within the maximum message size limit (or some other desired size) and is acceptable for communicating in a single transmission. If the compressed SMS message is within the desired size limit, no further compression is necessary and control may then flow back to block S300 of FIG. 3.

On the other hand, if the compressed SMS message exceeds the maximum message size limit, control flows to block S205. At this operation, each of the common words contained within the compressed SMS message are changed to an assigned common word. To enhance this compression operation, the common words and corresponding assigned words may be preloaded into memory 190. If desired, the changed words may be identified in the compressed SMS message using any of the previously described highlighting techniques. Control then flows to decision block S207.

Decision block S207 determines if the compressed SMS message (i.e., the SMS message having undesired spaces removed and certain words changed) is within the limits of the maximum message size (or some other desired size) and is acceptable for transmitting in a single transmission. If the compressed SMS message is within the maximum message size limit, no further compression is necessary (although possible) and control may flow back to block S300 of FIG. 3.

On the other hand, if the compressed SMS message exceeds this size limit, control flows to block S209. This optional operation confirms whether or not the user wants to delete special characters which are contained within the compressed SMS message. An example of such an inquiry is to ask: "Do you want to delete special characters?".

Decision block S211 determines whether or not the user wants to delete special characters. If the user does not want to delete these characters, control flows to block S212. According to this truncating operation, the portions of the compressed SMS message that exceed the maximum message size limit are removed. After performing the truncating operation, processing may flow to block S310 of FIG. 3.

Referring back to block S211, if the user requests deletion of special characters, control flows to block S213. At this operation, special characters contained within the currently compressed SMS message may be deleted or otherwise removed. This operation is typically accomplished by searching for the special characters within the SMS message starting at the beginning of the message, and then deleting the identified special characters in the order in with they appear in the message.

If desired, the location at which the special characters were deleted may be identified or otherwise highlighted in the compressed SMS message using any of the previously described identification techniques.

Decision block S215 determines if the compressed SMS message (i.e., the SMS message having undesired spaces and special characters removed, and certain words changed) is within the limit of the maximum message size limit (or some other desired size) and is acceptable for transmitting in a single transmission. If the compressed SMS message is within the size limit, no further compression is necessary (although possible) and control may flow back to block S300 of FIG. 3. On the other hand, if the compressed SMS message exceeds message size limit, control flows to block S212 so that the compressed SMS message may be appropriately truncated as previously described.

Note that at some point, the user may desire to view the original and uncompressed SMS message. As such, the user is provided with the capability to display the original SMS message. A benefit of this function is that the user can manually change the SMS message should the automated message compression process produce unacceptable results.

Various alternatives for compressing SMS messages are possible and are within the teachings of the present disclosure. First, the various operations depicted in FIGS. 3 and 4 are merely exemplary and no single order is required or desired. The order in which the various compression operations are performed may be modified to meet a particular need. In addition, greater or fewer compression operations may be used. If desired, the number and/or order of compression operations may be predetermined by the system, or they can be user defined. As another alternative, each individual compression process may also have a priority for which each process is performed. The priority may be system determined, user-defined, or combinations thereof.

Additional compression operations are also possible. For instance, in a manner similar to block 205, a SMS message may be compressed by changing certain words contained within the SMS message to an assigned abbreviation for an identified word. To enhance this compression operation, the words and assigned abbreviations may be preloaded into memory 190, and more particularly abbreviation database 195. If desired, the abbreviated words may be highlighted in the compressed SMS message using any of the previously described highlighting techniques.

An additional aspect would then determine if the compressed SMS message is within the limits of the maximum message size (or some other desired size) and is acceptable for transmitting in a single transmission. If the SMS message exceeds the size limit, the SMS message may be appropriately truncated as previously described.

FIGS. 5A-5D depict a portion of a display of a typical mobile terminal and individually show various aspects of message creation and compression according to various embodiments of the present invention.

FIG. 5A depicts an SMS creation window in which the SMS message can be created by a user. For simplicity and ease of discussion, the creation window is shown having a limit of 60 characters, but other size limits are of course possible. In Fig. 5B, the user has created a SMS message which has exceeded the maximum message size. Note that the window depicts an optional message size indicator in the upper portion of the window. This indicator shows that the created SMS message has exceed the maximum message size limit by 7%. This figure provides an example of an original SMS message which requires compression before transmitting to others.

In an embodiment, the user may select the "option" menu item, which may cause the rendering of the menu depicted FIG. 5C. Included in this menu, for example, is "automatic message compression" and "compressed message restoration" menu items. Selecting option 4 will restore a compressed SMS message back to its original and non-compressed condition. Selecting option 3 will launch the automatic message compression process, which may be accomplished using any of the SMS message compression processes described herein.

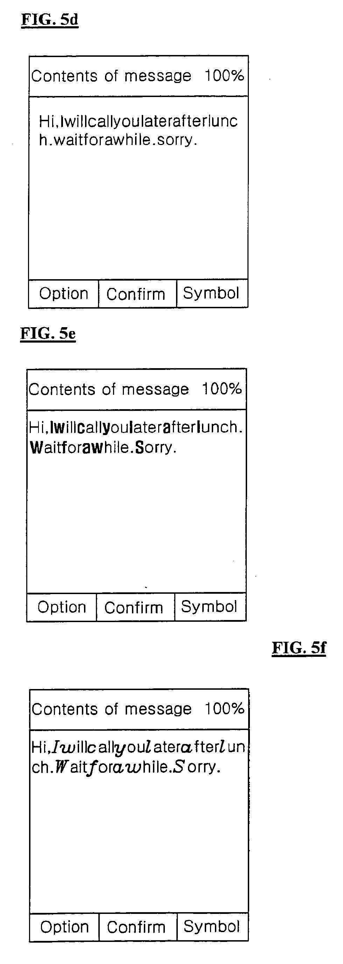

For example, FIG. 5D depicts a compressed SMS message in which excess spaces have been removed. This compression process is sufficient to reduce the size of the message so that it does not exceed the maximum message size limit. Further compression (e.g. common words, special characters, abbreviations, etc.) is not necessary, but may be performed if so desired. The compressed SMS message may now be communicated to others using a single transmission.

FIGS. 5E and 5F each depict compressed SMS messages in which changes made to the original message have been highlighted in the compressed SMS message. More specifically, FIG. 5E depicts highlighting (e.g., larger font) of characters in the compressed SMS message which were adjacent to the spaces removed from the original SMS message. Similarly, FIG. 5F depicts highlighting of the changes using both a larger font and italics.

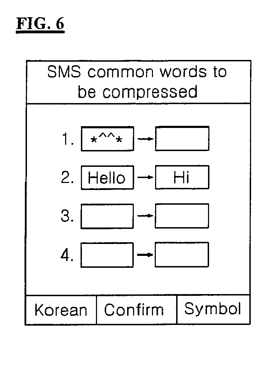

FIG. 6 depicts a registration window in which a user may register common words and corresponding assigned words. This feature may augment or replace the need for system-defmed common words and corresponding assigned words.

The foregoing embodiments and advantages are merely exemplary and are not to be construed as limiting the present invention. The present teaching can be readily applied to other types of apparatuses and processes. The description of the present invention is intended to be illustrative, and not to limit the scope of the claims. Many alternatives, modifications, and variations will be apparent to those skilled in the art.

## Claims

1. A method for compressing message content, said method comprising:
receiving an original message comprising user-supplied content, said original message having a message size which varies based upon said user-supplied content; and
generating a compressed message by modifying said user-supplied content according to at least one automatic compression process, wherein said compressed message has a message size which is less than said message size of said original message.

2. The method according to claim 1, wherein said compression process comprises:
removing any spaces individually located between separate characters contained within said user-supplied content.

3. The method according to claim 2, wherein said removing is performed until said message size of said compressed message meets a predetermined size threshold.

4. The method according to claim 1, wherein said compression process comprises:
changing predetermined common words contained within said user-supplied content into a relatively smaller assigned word.

5. The method according to claim 1, wherein said compression process comprises:
removing any special characters contained within said user-supplied content.

6. The method according to claim 1, wherein said compression process comprises:
changing any words contained within said user-supplied content that have assigned abbreviations into said abbreviations.

7. The method according to claim 1, said method further comprising:
removing any characters contained within said user-supplied content which exceed a maximum message size limit.

8. The method according to claim 1, said method further comprising:
setting priority which determines relative order for each operation of said compression process.

9. The method according to claim 1, said method further comprising:
detecting that said message size of said original message exceeds a predetermined size threshold.

10. The method according to claim 1, said method further comprising:
highlighting portions of said compressed message which correspond to said user-supplied content modified according to said compression process.

11. The method according to claim 10, wherein said highlighting comprises:
displaying said highlighted portions of said compressed message in at least one of a different color, font, and size than that used to display non-highlighted portions of said compressed message.

12. The method according to claim 1, said method further comprising:
registering common words with assigned words suitable for said compression process.

13. The method according to claim 1, wherein said generating said compressed message is performed responsive to user input.

14. The method according to claim 1, wherein said generating said compressed message is performed automatically whenever said original message exceeds a predetermined size threshold.

15. The method according to claim 1, said method further comprising:
displaying a message size indicator which represents said message size of said original message.

16. The method according to claim 1, said method further comprising:
restoring said compressed message to said original message responsive to user input.

17. The method according to claim 1, wherein said compressed message is a message selected from the group consisting of a short message service (SMS) message, an enhanced message service (EMS) message, and a multimedia message service (MMS) message.

18. A mobile terminal, comprising:
a key input unit for receiving an original message comprising user-supplied content, said original message having a message size which varies based upon said user-supplied content; and
a control unit for generating a compressed message by modifying said user-supplied content according to at least one automatic compression process, wherein said compressed message has a message size which is less than said message size of said original message.

19. The mobile terminal according to claim 18, wherein said control unit is further configured to:
remove any spaces individually located between separate characters contained within said user-supplied content.

20. The mobile terminal according to claim 18, wherein said control unit is further configured to:
change predetermined common words contained within said user-supplied content into a relatively smaller assigned word.

21. The mobile terminal according to claim 18, wherein said control unit is further configured to:
remove any special characters contained within said user-supplied content.

22. The mobile terminal according to claim 18, wherein said control unit is further configured to:
change any words contained within said user-supplied content that have assigned abbreviations into said abbreviations.

23. The mobile terminal according to claim 18, wherein said control unit is further configured to:
highlight portions of said compressed message which correspond to said user-supplied content modified according to said compression process.

24. The mobile terminal according to claim 18, wherein said control unit is further configured to:
remove any characters contained within said user-supplied content which exceed a maximum message size limit.

25. The mobile terminal according to claim 18, wherein said control unit is further configured to:
set priority which determines relative order of performance that individual compression processes of said at least one automatic compression process is performed.

26. The mobile terminal according to claim 18, further comprising:
registration unit for registering common words with assigned words suitable for said compression process.

27. The mobile terminal according to claim 18, further comprising:
a message size indicator which represents said message size of said original message.

28. The mobile terminal according to claim 18, further comprising:
a restoring unit for restoring said compressed message to said original message responsive to user input.

29. The mobile terminal according to claim 18, wherein said compressed message is a message selected from the group consisting of a short message service (SMS) message, an enhanced message service (EMS) message, and a multimedia message service (MMS) message.

30. A control unit for a mobile terminal, said control unit configured to:
receive an original message comprising user-supplied content, said original message having a message size which varies based upon said user-supplied content; and
generate a compressed message by modifying said user-supplied content according to at least one automatic compression process, wherein said compressed message has a message size which is less than said message size of said original message.

31. The control unit according to claim 30, wherein said control unit is further configured to:
remove any spaces individually located between separate characters contained within said user-supplied content;
change predetermined common words contained within said user-supplied content into a relatively smaller assigned word;
remove any special characters contained within said user-supplied content; and
change any words contained within said user-supplied content that have assigned abbreviations into said abbreviations.

32. The control unit according to claim 30, wherein said control unit is further configured to:
display a message size indicator which represents said message size of said original message.
